# FASCICULE DE BREVET EUROPEEN

(11) **EP 0 352 183 B1**
(45) Date de publication et mention de la délivrance du brevet: **01.09.1993**
(21) Numéro de dépôt: 89402041.1
(22) Date de dépôt: 18.07.1989
(51) Int. Cl.: H05K 3/34, H01L 23/498

(54) **Procédé de montage de micro-composants électroniques sur un support et produit intermédiaire**
Verfahren zum Montieren elektronischer Mikrokomponenten auf einer Unterlage und Zwischenprodukt
Process for mounting electronic micro components on a support, and intermediate product

(30) Priorité: 20.07.1988 FR 8809819
(43) Date de publication de la demande: 24.01.1990
(73) Titulaire: MATRA MARCONI SPACE FRANCE, 75116 Paris (FR)
(72) Inventeur: De Givry, Jacques, F-78350 Les Loges en Josas (FR); Vallet, Jean-Claude, F-78140 Velizy (FR); Lalfer, Jean-Paul, F-78000 Versailles (FR)
(74) Mandataire: Fort, Jacques

(56) Documents cités:
- EP-A- 0 095 391
- WO-A-88/05428
- FR-A- 2 360 174
- FR-A- 2 479 639
- FR-A- 2 523 397
- GB-A- 2 149 581
- US-A- 4 750 080

## Description

La présente invention a pour objet un procédé pour monter, sur un support de circuit imprimé, des micro-composants électroniques à fixer à plat et munis, sur leur face inférieure, de contacts soudables et pour les relier au circuit imprimé, ainsi qu'un produit intermédiaire. L'invention permet notamment de fixer, sur le support, un micro- composant ayant un coefficient de dilatation thermique nettement différent de celui du support, même s'il a des dimensions importantes.

Une application particulièrement importante, bien que non exclusive, du procédé est constituée par le montage de micro-composants dénommés "chip carriers" ou "porte-puce", démunis de patte de fixation et dont l'encombrement est très inférieur à celui des boîtiers de circuit intégré classiques. Il est cependant applicable aussi à d'autres micro-composants dont le matériau est mal adapté, du point de vue dilatation thermique, au support destiné à les recevoir. C'est le cas par exemple de divers circuits passifs (réseaux de résistances en particulier) à fixer sur substrat de céramique ou circuits imprimés et munis à leur périphérie d'encoches métallisées de liaison.

Les porte-puce ont un socle céramique muni sur sa face inférieure de contacts permettant de le fixer à plat sur un support. La différence entre les coefficients de dilatation de la céramique et du stratifié verre-époxy ou verre-polyimide qui constitue la plupart des supports de circuit imprimé habituels conduit à des montages qui ne peuvent supporter des cyclages thermiques. En particulier, les contraintes dues aux dilatations différentielles risquent de détruire les contacts.Divers palliatifs ont été proposés pour résoudre ce problème. On a notamment réalisé des porte-puce munis de pattes de liaison ayant une forme dite "en aile de mouette" pour qu'elles tolérent des dilatations différentielles entre socle et support. La souplesse de ces pattes est limitée et il n'existe que quelques dimensions de porte-puce munis de telles pattes. Une autre solution pour compenser les phénomènes de contrainte d'origine thermique est l'emploi de supports en un matériau ayant un coefficient de dilatation thermique comparable à celui de la céramique. On a notamment utilisé des supports constitués par du quartz, des produits co-laminés, des matières synthétiques telles que les "kevlar". Ces supports sont coûteux et difficiles à obtenir en grande dimension. US-A-4 750 089 décrit l'utilisation d'une cale pour fixer le socle sur le support.

Le document FR-A-2 523 397 décrit un procédé permettant de résoudre le problème des dilatations thermiques différentielles dans le cas où le support porte des pastilles de soudage entre lesquelles les liaisons équipotentielles sont réalisées par des tronçons de fil souple isolé et non par des pistes imprimées. Suivant ce procédé, on fixe à plat le composant au support par des moyens de liaison mécanique capables de tolérer des dilatations différentielles, constituées par un intercalaire en un matériau compatible thermiquement avec le micro-composant et on réalise des liaisons électriques par soudage des contacts du micro-composant sur un réseau conducteur prévu sur l'intercalaire et débordant du composant. Ce procédé est cependant surtout applicable à la réalisation de circuits à fabriquer en petit nombre, du fait du nombre de liaisons à créer manuellement.

On connaît également (FR-A-2 479 639) un procédé de montage de micro-composants utilisant des "ponts" constitués de bandes métalliques. Mais la façon dont ces "ponts" peuvent être raccordés n'apparaît pas et il semble bien que ce soit ces bandes qui constituent les moyens essentiels pour porter le micro-composant.

La présente invention vise notamment à permettre de monter des micro-composants à fixer à plat sur tout type de support, tel qu'une carte de circuit imprimé classique (éventuellement multi-couches) ou une carte de circuit à couche épaisse ou à couche mince. Elle vise également à fournir un procédé non seulement applicable aux porte-puce classiques ayant jusqu'à 84 sorties réparties avec un pas de 1,27 mm, mais aussi extrapolable aux porte-puce ayant jusqu'à 228 contacts de sortie et à ceux dont les contacts de sortie sont répartis au pas de 0,635 mm, encore peu courant.

Dans ce but l'invention propose notamment un procédé suivant la revendication 1.

Les moyens de liaison mécanique sont avantageusement constitués par une cale de dimensions en plan inférieures à celles du composant pour dégager les contacts soudables, en un matériau ayant un coefficient de dilatation comparable à celui du micro-composant. Ce matériau, placé au droit de la cavité du porte-puce qui reçoit le composant actif, doit avoir un interface aussi conducteur de la chaleur que possible avec le porte-puce et avec le support et il permet d'évacuer la chaleur dégagée par le composant actif. La cale a une hauteur suffisante pour que les tronçons de fils souples aient une courbure telle que la dilatation différentielle du support et du composant provoque simplement une modification de cette courbure, sans mise en tension des tronçons de fils : une épaisseur de cale comprise entre 0,3 et 0,5 mm donne en général des résultats satisfaisants.

Dans un premier mode de mise en oeuvre de l'invention, qui se prête notamment à la réalisation de prototypes, les tronçons de fil souple sont réalisés individuellement en fil de cuivre étamé, ou émaillé lorsque des tronçons de fil doivent se croiser. Ces tronçons sont d'abord fixés sur le porte-puce. La cale est collée sur le porte-puce. Enfin les tronçons de fil sont brasés sur le support en mode automatique ou manuel. On peut notamment effectuer cette opération en utilisant les moyens décrits dans les documents FR-A-2 191 399, 2 327 019 et 2 327 025 de la société demanderesse.

L'invention propose également un produit intermédiaire comprenant un micro-composant électronique à fixer à plat et muni, sur une face destinée à être fixée sur un support, de contacts, une grille ayant une bande de rive reliant les extrémités externes de tronçons de liaison soudés aux contacts et une cale en matériau ayant un coefficient de dilatation compatible avec celui du micro- composant, de dimensions en plan inférieures à celles du micro-composant et collée sous le micro-composant.

L'invention sera mieux comprise à la lecture de la description qui suit de divers modes de mise en oeuvre, donnés à titre d'exemples non limitatifs. La description se réfère aux dessins qui l'accompagnent, dans lesquels :
- la figure 1 est un schéma en coupe suivant un plan perpendiculaire au support, montrant un produit résultant de la mise en oeuvre du procédé, comportant un micro-composant du type "porte-puce" sur un support de circuit imprimé ;
- la figure 2 est une vue en perspective d'un appareil permettant de souder automatiquement des tronçons de fil sur un micro-composant avant de le reporter sur le support ;
- la figure 3 est un schéma en perspective, en coupe partielle, montrant un fragment de produit intermédiaire obtenu par mise en oeuvre d'une variante du procédé ;
- la figure 4 montre un fragment d'une grille utilisable pour la mise en oeuvre de cette variante ;
- la figure 5, similaire à la figure 3, montre les tronçons de fils de liaison après soudage sur le micro-composant et découpage de la zone interne ;
- la figure 6 est une vue de détail, sur laquelle l'échelle n'est pas respectée, montrant une zone de rétrécissement de tronçons de fil de liaison appartenant à la grille de la figure 4 ;
- la figure 7 est un schéma en perspective montrant un mode de soudage collectif des tronçons de fil de contact de la grille de la figure 4 sur le micro-composant.

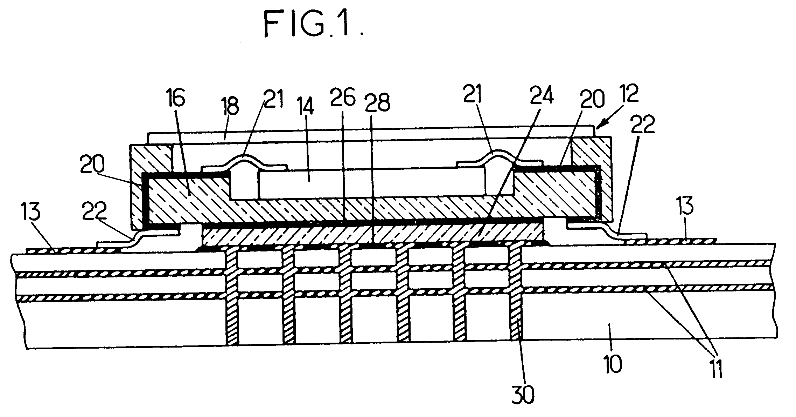

Le produit montré schématiquement sur la figure 1 comporte un support 10 de circuit imprimé qui, dans le mode de réalisation montré, présente des plans intermédiaires métallisés 11 de masse et d'évacuation thermique, par exemple en cuivre.

Bien que l'invention permette d'utiliser des supports de circuits imprimés constitués de façon traditionnelle en composite verre-époxy, il sera généralement avantageux, dans le cas où l'on cherche à obtenir des circuits à hautes performances et fiabilité dans l'espace, un support en stratifié quartz-polyimide ou verre-polyimide qui se trouve maintenant couramment dans le commerce et ont des caractéristiques constantes. Le support porte des pistes conductrices terminées par des pastilles de soudage 13.

Le support 10 porte des micro- composants qui peuvent être de natures diverses. Seul est représenté un porte-puce 12 contenant un circuit intégré 14. Le porte-puce est constitué d'un socle 16 en matériau céramique, fermé par un capot 18.

La puce de circuit intégré 14 est reliée aux contacts soudables 20 du porte-puce de façon quelconque, par exemple par des liaisons 21 qui ne sont pas concernées directement par l'invention. Mais, conformément à l'invention, le porte-puce est équipé de tronçons 22 d'un fil souple de liaison qui sera généralement du fil de cuivre étamé de faible diamètre (0,14 mm par exemple). Chacun des tronçons de fil 22 relie un des contacts 20 du porte-puce à une pastille 13 du support de circuit imprimé.

Pour surélever le porte-puce 12 par rapport au support 10 et obliger les tronçons de fil 22 à prendre une courbure qui les soustrait ultérieurement aux contraintes mécaniques, le porte-puce 12 n'est pas fixé directement au support 12. Une cale 24 en matériau ayant un coefficient de dilatation thermique comparable à celui du socle 16 est intercalé entre le support et le socle. Cette cale peut notamment être en alumine ou en oxyde de béryllium. L'épaisseur de la cale sera généralement comprise entre 0,3 et 0,5 mm.

Les dimensions en plan de la cale 24 sont inférieures à celles du socle, de façon que la cale reste écartée des contacts soudables 20. Il est en conséquence possible de la constituer en un produit qui est un conducteur électrique, dans la mesure ou le support n'a pas de piste métallique au dessous. La cale 24 est fixée au socle par collage, par exemple à l'aide d'une pellicule adhésive 26 du type désigné par la marque "Ablestick". La cale 24 est fixée sur le support 10 à l'aide d'un vernis 28, généralement d'un vernis polyuréthane, déposé au moins sur la partie centrale de la cale, c'est-à-dire à l'endroit où devra s'écouler le flux thermique dû à l'échauffement de la puce et où l'interface doit présenter une impédance thermique aussi faible que possible.

Dans le cas illustré sur la figure 1, la chaleur est évacuée vers les plans de masse 11 par le métal revêtant ou occupant les trous 30 traversant le support 10 et en contact avec eux. Le transfert thermique est ainsi assuré dans de bonnes conditions, le fond du socle étant plaqué sur la cale, elle-même en bon contact thermique avec la métallisation des trous.

Le procédé peut être mis en oeuvre par les étapes successives suivantes.

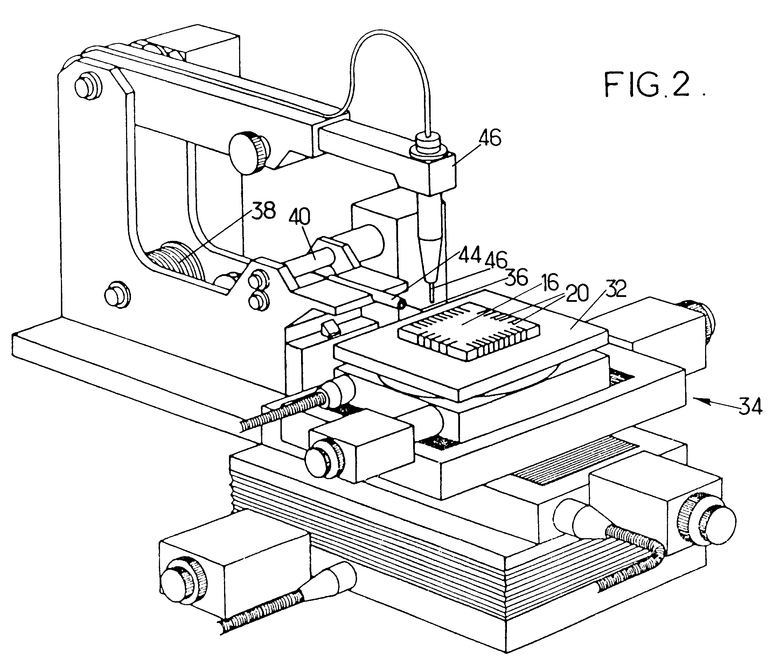

Le socle du porte-puce 16 est d'abord équipé de tronçons 22 de fil souple étamé. Pour cela on peut utiliser un appareil du genre montré en figure 2. Le socle 12 est plaqué, par exemple par aspiration, sur un plateau rotatif 32 porté par une table 34 à mouvements croisés et à avance pas à pas. Les moyens de liaison du plateau 32 à la table 34 sont prévus pour permettre de donner au plateau des orientations à 90° les unes des autres. L'appareil comporte également des moyens pour débiter le fil émaillé 36 nécessaire. Ces moyens peuvent notamment comporter une bobine de fil 38, des rouleaux 40 munis d'un moteur d'avance du fil, chaque fois d'une longueur prédéterminée, et un capillaire de guidage 44. L'appareil comprend encore une potence 46 basculant dans le sens vertical et équipée d'une torche de soudage électrique 46. Une fois le socle 16 pré-étamé et fixé sur le plateau 32, la table 34 est commandée pour placer le premier contact 20 sous la torche 46, puis les soudures peuvent être effectuées de façon automatique. Le socle est ensuite repris avec une buse d'aspiration, permettant de ne pas toucher aux tronçons de fil.

L'étape suivante consiste à équiper le socle 16 de sa cale 24. Pour cela le socle 16 est posé sur la cale, munie d'une pellicule adhésive, dans une presse chauffante qui amorce le processus de polymérisation de la pellicule adhésive. Une goutte de vernis est déposée sur la cale, à l'opposé de la pellicule adhésive et l'ensemble est mis en place sur le support de circuit imprimé. Les tronçons de fil sont alignés avec les pastilles de soudage prévues sur le support et des brasures sont réalisées individuellement avec un appareillage qui peut être d'un des types décrits dans les documents FR mentionnés plus haut. Le brasage sur le support ne refond pas la soudure déjà effectuée sur le socle.

Une fois que tous les micro-composants destinés à équiper le support ont été mis en place, l'ensemble est porté en étuve pour achever la polymérisation des pellicules adhésives et des vernis.

Il est important de noter qu'un micro-composant défectueux peut être retiré : un tronçon de fil peut être arraché en laissant un sillon dans lequel pourra ultérieurement être replacé un autre fil. On connaît des vernis dont la résistance au cisaillement est suffisamment faible pour qu'on puisse retirer le porte-puce par simple torsion.

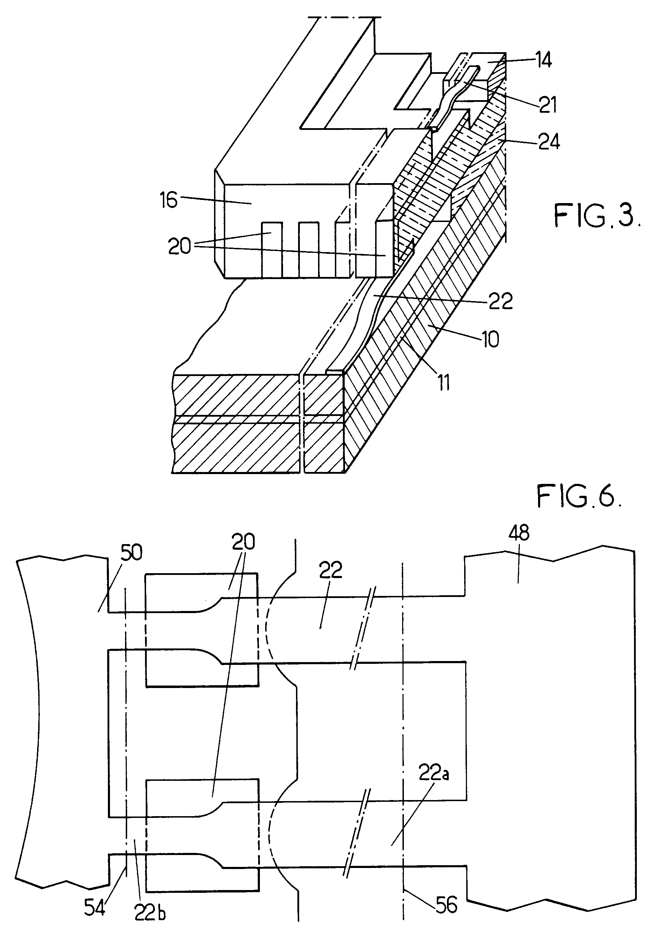

Dans la variante de réalisation de l'invention montrée en figure 3, les tronçons de fil de liaison 22 à fixer sur un même micro-composant sont initialement solidaires d'une bande de rive 48 et d'une zone centrale 50 (figure 4), de sorte que l'ensemble constitue une grille découpée dans une feuille mince (100 µm par exemple). Une ouverture est ménagée dans la zone centrale 50 pour permettre de saisir directement le micro-composant à l'aide d'une buse d'aspiration et éventuellement recharger le micro-composant en soudure qui est ensuite répartie par centrifugation. Les tronçons présentent une partie principale 22a ayant la largeur souhaitée pour réaliser les tronçons de fil de liaison et une partie rétrécie 22b qui est destinée à être coupée après soudage des tronçons 22 sur les contacts 20. Les parties 22a et 22b peuvent notamment avoir des largeurs respectives de 200 µm et 100 µm.

Le procédé suivant l'invention est alors mis en oeuvre de la façon suivante.

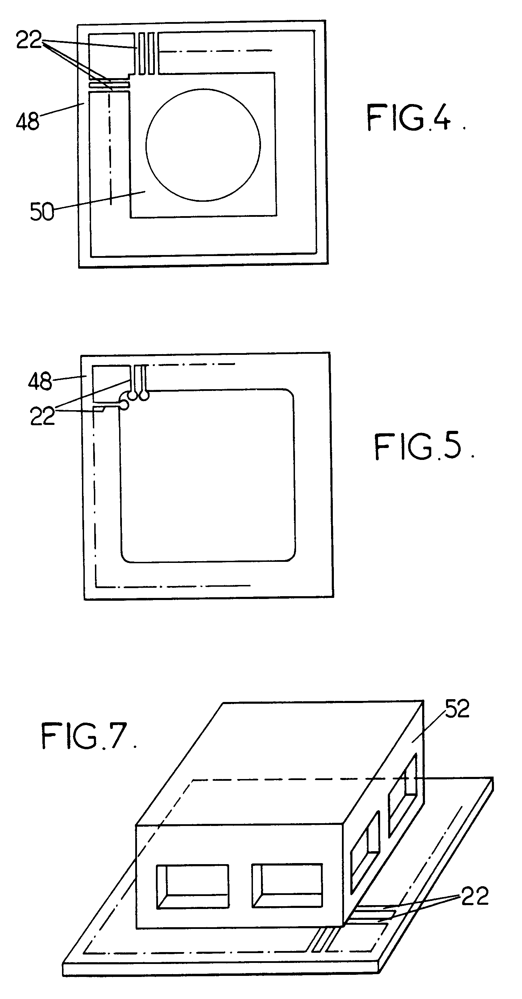

La grille est posée sur le socle 16 dont les contacts 20 ont été pré-étamés, par exemple par dépôt d'étain fondu puis centrifugation. Après contrôle de la mise en place correcte de la grille, les tronçons 22 sont soudés à la fois à l'aide d'une électrode chauffante 52 de forme appropriée (figure 7). La zone centrale 50 est séparée, par exemple par découpe à l'aide d'un couteau venant s'appuyer sur les parties étroites 22b, le long de la ligne 54 de la figure 6. Une pression réduite du couteau est suffisante, du fait de la faible épaisseur des tronçons 22 et la faible largeur des parties 22b. Une fois la zone centrale enlevée, le socle équipé présente l'aspect montré en figure 5. Il constitue un produit intermédiaire qui peut être commercialisé et conservé dans cet état jusqu'à montage définitif. La bande de rive 48 constitue un cadre qui maintient tous les contacts au même potentiel et évite le risque d'apparition de tension différentielle élevée qui pourrait endommager la puce portée par le porte-puce. De plus la bande de rive 48 maintient tous les tronçons 22 à l'écartement correct, notamment au cours de manipulations et lors du collage de la cale 24.

Juste avant montage et brasage sur un support, la bande de rive 48 est ôtée par sectionnement à l'aide d'un couteau, par exemple le long de la ligne 56 (figure 6). Tous les contacts peuvent encore être brasés à la fois avec une électrode chauffante du même genre que celle montrée en figure 7. Du fait de la présence de la cale 24, l'appui de l'électrode chauffante donne automatiquement au tronçon 22 la courbure requise pour qu'il puisse supporter ultérieurement les dilatations différentielles sans être mis en tension.

Un micro-composant fixé et raccordé par mise en oeuvre du mode de réalisation des figures 3 à 7 peut être retiré et remplacé. Pour cela on désoude les tronçons 22 du support 10, par exemple à l'aide d'un jet de gaz chaud. Le micro-composant peut ensuite être retiré en fracturant le vernis par torsion, dans la mesure où on a utilisé un vernis résistant mal au cisaillement, tel que le "solithane". La soudure restante peut être enlevée par chauffage et centrifugation avant rechargement.

On voit que le procédé suivant l'invention permet de fixer à plat des micro-composants sur des supports qui reçoivent également des micro-composants à pattes traversantes. Ce support n'a pas besoin d'être en matériau à coefficient de dilatation comparable à celui de la céramique constituant par exemple les porte-puce. Le support peut en particulier être une carte de circuit imprimé en composite verre-époxy ou, surtout lorsque le circuit final est destiné à être utilisé dans l'espace, un composite verre-polyimide. Les connexions réalisées sont courtes, ce qui est un élément favorable en hyperfréquence. Les supports utilisés peuvent être d'un type permettant de réaliser des pistes par photolithographie, qui permet d'atteindre des épaisseurs plus faibles que la sérigraphie, seul procédé utilisable à l'heure actuelle sur la céramique.

L'invention ne se limite pas aux modes particuliers de réalisation qui ont été représentés et décrits à titre d'exemples. Elle est susceptible de nombreuses variantes. En particulier, les micro-composants munis de leur cale et des tronçons de fil de jonction peuvent être fixés sur le support par des procédés autres que le brasage, et notamment par soudage à refusion en phase gazeuse.

## Revendications

1. Procédé pour monter, sur un support (10) portant un circuit imprimé, des micro-composants électroniques à fixer à plat et munis, sur leur face inférieure, de contacts soudables (20) et pour relier ces micro-composants au circuit, suivant lequel on fixe à plat le composant au support par l'intermédiaire de moyens de liaison mécanique capables de tolérer des dilatations différentielles, caractérisé en ce que l'on relie les contacts (20) du micro-composant au circuit imprimé par l'intermédiaire de tronçons (22) de fil souple présentant une courbure suffisante pour assurer un découplage mécanique, tous les tronçons (22) de fil de liaison à fixer sur un même micro-composant étant fixés en une seule opération sur l'ensemble des contacts (20) du micro-composant, et étant encore solidarisés d'une bande de rive (48) et d'une zone centrale (50) qu'on sépare ensuite.

2. Procédé selon la revendication 1, caractérisé en ce que lesdits tronçons, la bande de rive et la zone centrale constituent une grille ayant une épaisseur d'environ 100 µ.

3. Procédé selon la revendication 1 ou 2, caractérisé en ce que les moyens de liaison mécanique sont constitués par une cale (24) de dimensions en plan inférieures à celles d'un socle (16) du composant, laissant les contacts (20) accessibles.

4. Procédé selon la revendication 3, caractérisé en ce que la cale a une épaisseur comprise entre 0,3 et 0,5 mm.

5. Procédé selon l'une quelconque des revendications précédentes, caractérisé en ce que les tronçons (22) de fil souple sont réalisés individuellement en fil de cuivre étamé ou émaillé.

6. Produit intermédiaire comprenant un micro-composant électronique à fixer à plat et muni, sur une face destinée à être fixée sur un support, de contacts (20), une grille ayant une bande de rive (48) reliant les extrémités externes de tronçons (22) de fil souple de liaison soudés aux contacts (20) et une cale (24) en matériau ayant un coefficient de dilatation compatible avec celui du micro-composant, de dimensions en plan inférieures à celles du micro-composant et collée sous le micro-composant.

7. Produit intermédiaire selon la revendication 6, caractérisé en ce que la cale a une épaisseur comprise entre 0,3 et 0,5 mm.

8. Produit intermédiaire selon la revendication 6 ou 7, caractérisé en ce que le micro-composant est un porte-puce ayant une cavité centrale de réception d'une puce de circuit intégré.

9. Produit intermédiaire selon la revendication 6, 7 ou 8, caractérisé en ce que lesdits tronçons présentent une zone externe de largeur supérieure à celle d'une zone interne (22b) débordant vers l'intérieur des contacts (20).

## Claims

1. A process for flat mounting electronic microcomponents on a printed circuit support, said microcomponents having solderable contacts (20) on their lower face and for connecting said microcomponents to the circuit, comprising fastening the component flat on the support through mechanical connection means able to tolerate differential expansion,
characterized by the steps of connecting the contact (20) of the microcomponent to the printed circuit through sections (22) of flexible wire having a sufficient degree of curvature for mechanical uncoupling, all sections (22) of connection wire to be secured onto a same microcomponent being secured in a single operation on all contacts (20) of the microcomponent and being further fast with an edge strip (48) and a central zone (50) which are later removed.

2. Method according to claim 1,
characterized in that said sections, said edge strip and said central zone constitute a grid having a thickness of about 100 µ.

3. Method according to claim 1 or 2,
characterized in that the mechanical connection means comprise a spacer (24) having planar dimensions lesser than those of a base (16) of the component, for providing access to the contacts (20).

4. Method according to claim 3,
characterized in that the spacer has a thickness of from 0.3 to 0.5 mm.

5. Method according to any one of the preceding claims,
characterized in that the sections of flexible wire are individually made of tin-coated or enamelled copper wire.

6. Intermediate product comprising an electronic microcomponent to be fixed flat on a support and having, on a face for connection on a support, of contacts (20), a grid having an edge band (48) coonecting the external ends of sections (22) of flexible connection wires which are soldered to the contacts (20) and a spacer (24) of a material an expansion coefficient compatible with that of the microcomponent, whose planar dimensions are less than those of the microcomponent and which is bonded under the microponent.

7. Intermediate product according to claim 6,
characterized in that the spacer has a thickness comprised between 0.3 and 0.5 mm.

8. Intermediate product according to claim 6 or 7,
characterized in that a microcomponent is a chip carrier having a central recess for receiveing an integrated circuit chip.

9. Intermediate product according to claim 6, 7 or 8,
characterized in that said sections have an external zone whose width is higher than that of an internal zone (22b) which has an inner overlap on the contacts (20).

## Patentansprüche

1. Verfahren zum Montieren elektronischer Mikrokomponenten auf einer Unterlage (10), die einen gedruckten Schaltkreis trägt, wobei die Mikrokomponenten flächig zu fixieren sind und auf ihrer unteren Seite mit lötbaren Kontakten (20) versehen sind, und zum Verbinden dieser Mikrokomponenten mit dem Schaltkreis, demgemäß die Komponenten auf der Unterlage mittels mechanischer Verbindungsmittel, die differenzielle Ausdehnungen zulassen, flächig fixiert werden,
**dadurch gekennzeichnet**, daß die Kontakte (20) der Mikrokomponenten mittels biegsamer Drahtstücke (22) mit dem Schaltkreis verbunden werden, die eine ausreichende Krümmung aufweisen, um eine mechanische Entkopplung sicherzustellen, wobei alle auf einer Mikrokomponente zu fixierenden Verbindungsdrahtstücke (22) durch einen einzigen Arbeitsschritt auf der Gesamtheit der Kontakte (20) der Mikrokomponenten fixiert werden, und noch durch ein Seitenband (48) und einen Zentralbereich (50) verbunden werden, die anschließend abgetrennt werden.

2. Verfahren nach Anspruch 1, **dadurch gekennzeichnet**, daß die besagten Stücke, das Seitenband und der Zentralbereich ein Gitter mit einer Dicke von ungefähr 100 µ bilden.

3. Verfahren nach Anspruch 1 oder 2, **dadurch gekennzeichnet**, daß die mechanischen Verbindungsmittel ein Unterlegteil (24) umfassen, dessen Flächenausdehnung kleiner als die eines Sockels (16) der Komponente ist, wobei die Kontakte (20) zugänglich bleiben.

4. Verfahren nach Anspruch 3, **dadurch gekennzeichnet**, daß das Unterlegteil eine inklusive Dicke zwischen 0,3 und 0,5 mm aufweist.

5. Verfahren nach einem der vorangegangenen Ansprüche, **dadurch gekennzeichnet**, daß die biegsamen Drahtstücke (22) einzeln aus verzinkten oder emaillierten Kupferdraht gefertigt sind.

6. Zwischenprodukt, bestehend
aus einer elektronischen Mikrokomponente, die flächig zu fixieren ist und auf der Seite, die auf einer Unterlage fixiert werden soll, mit Kontakten (20) versehen ist,
aus einem Gitter, das ein Seitenband (48) umfaßt, welches die äußeren Enden von biegsamen Verbindungsdrahtstücken (22), die an die Kontakte (20) gelötet sind, umfaßt
und aus einem Unterlegteil (24) eines Materials, das einen Ausdehnungskoeffizienten aufweist, der vergleichbar mit dem der Mikrokomponente ist und eine Flächenausdehnung aufweist, die kleiner ist als die der Mikrokomponenten und unter der Mikrokomponente vorgesehen ist.

7. Zwischenprodukt nach Anspruch 6, **dadurch gekennzeichnet**, daß der Unterlegteil eine inklusive Dicke zwischen 0,3 und 0,5 mm aufweist.

8. Zwischenprodukt gemäß Anspruch 6 oder 7, **dadurch gekennzeichnet**, daß die Mikrokomponente ein Substrat umfaßt, das eine zentrale Aussparung zur Aufnahme eines integrierten Schaltkreissubstrates aufweist.

9. Zwischenprodukt nach Anspruch 6, 7 oder 8, **dadurch gekennzeichnet**, daß die Stücke einen äußeren Bereich darstellen, dessen Breite größer als die eines inneren Bereiches (22b) ist, der gegen das Innere der Kontakte (20) hervorsteht.
